# EUROPEAN PATENT APPLICATION

(11) **EP 2 511 966 A2**
(43) Date of publication of application: **17.10.2012**
(21) Application number: 12161748.4
(22) Date of filing: 28.03.2012
(51) Int. Cl.: H01L 33/56, H01L 33/50

(54) **Reflecting resin sheet, light emitting diode device and producing method thereof**

(30) Priority: 14.04.2011 JP 2011089939
(71) Applicant: Nitto Denko Corporation, Osaka 567-8680 (JP)
(72) Inventor: Ooyabu, Yasunari, Osaka, 567-8680 (JP); Ito, Hisataka, Osaka, 567-8680 (JP); Naito, Toshiki, Osaka, 567-8680 (JP)
(74) Representative: HOFFMANN EITLE

(57) **Abstract**

A reflecting resin sheet (13) provides a reflecting resin layer (4) at the side of a light emitting diode element (3) and includes a first release substrate (21) and the reflecting resin layer (4) provided on one surface in a thickness direction of the first release substrate. In the first release substrate and the reflecting resin layer, a through hole (9) extending therethrough in the thickness direction is formed corresponding to the light emitting diode element (3) so as to allow an inner circumference surface of the through hole in the reflecting resin layer to be disposed in opposed relation to a side surface of the light emitting diode element.

## Description

### BACKGROUND OF THE INVENTION

### Field of the Invention

The present invention relates to a reflecting resin sheet, a light emitting diode device, and a producing method thereof, to be specific, to a producing method of a light emitting diode device, a reflecting resin sheet used in the producing method, and a light emitting diode device obtained by the producing method of the light emitting diode device.

### Description of Related Art

In recent years, as a light emitting device that is capable of emitting high-energy light, a white light emitting device has been known. In the white light emitting device, for example, a diode board; an LED (light emitting diode) laminated thereon, emitting blue light; a phosphor layer that can convert the blue light into yellow light and covers the LED; and an encapsulating layer that encapsulates the LED are provided. The white light emitting device emits high-energy white light by color mixing of the blue light emitted from the LED, which is encapsulated by the encapsulating layer and to which electric power is supplied from the diode board, transmitting through the encapsulating layer and the phosphor layer, and the yellow light that is converted in wavelength from a part of the blue light in the phosphor layer.

As a method for producing the white light emitting device, for example, the following method has been proposed (ref: for example, Japanese Unexamined Patent Publication No. 2005-191420).

The proposed method is as follows. That is, a base, which has a board portion and a white reflecting frame portion protruding from the circumference portion thereof toward the upper side, is first formed. Next, a semiconductor light emitting element is subjected to a wire bonding in a bottom portion of a concave portion, which is formed at the center of the board portion by the reflecting frame portion, so as to be spaced apart from the inner side of the reflecting frame portion.

Next, a mixture of a phosphor and an epoxy resin in a liquid state is filled in the concave portion by application, subsequently the phosphor is spontaneously precipitated in the bottom portion of the concave portion, and then the epoxy resin is heat cured.

In the white light emitting device obtained by the method proposed in Japanese Unexamined Patent Publication No. 2005-191420, the phosphor layer (a wavelength conversion layer) that contains the phosphor formed by a precipitation at high concentrations is defined in a region at the upper side of the semiconductor light emitting element and an encapsulating portion that contains the epoxy resin at high concentrations is defined in a region at the upper side of the phosphor layer.

In the white light emitting device, the semiconductor light emitting element radially emits the blue light. Of the emitted blue light, a part thereof emitted from the semiconductor light emitting element toward the upper side is converted into the yellow light in the phosphor layer and the remaining light transmits through the phosphor layer. The blue light emitted from the semiconductor light emitting element toward the side is reflected at the reflecting frame portion and then toward the upper side. The white light emitting device in Japanese Unexamined Patent Publication No. 2005-191420 emits the white light by color mixing of the blue light and the yellow light.

### SUMMARY OF THE INVENTION

However, in the white light emitting device obtained by the producing method in Japanese Unexamined Patent Publication No. 2005-191420, there is a disadvantage that the semiconductor light emitting element is spaced apart from the reflecting frame portion, so that a part of the light emitted from the semiconductor light emitting element toward the side is absorbed in the encapsulating portion before being reflected at the reflecting frame portion and as a result, extraction efficiency of the light is reduced.

It is an object of the present invention to provide a light emitting diode device that is capable of improving extraction efficiency of light, a producing method thereof, and a reflecting resin sheet used in the producing method.

A reflecting resin sheet of the present invention, for providing a reflecting resin layer at the side of a light emitting diode element, includes a first release substrate and the reflecting resin layer provided on one surface in a thickness direction of the first release substrate, wherein, in the first release substrate and the reflecting resin layer, a through hole extending therethrough in the thickness direction is formed corresponding to the light emitting diode element so as to allow an inner circumference surface of the through hole in the reflecting resin layer to be disposed in opposed relation to a side surface of the light emitting diode element.

In the reflecting resin sheet, the through hole is formed corresponding to the light emitting diode element so as to allow the inner circumference surface of the through hole in the reflecting resin layer to be disposed in opposed relation to the side surface of the light emitting diode element. Accordingly, the light emitting diode element can be disposed in the through hole such that the inner circumference surface of the through hole in the reflecting resin layer is disposed in opposed relation to the side surface of the light emitting diode element. Therefore, it is possible to reliably bring the reflecting resin layer into close contact with the side surface of the light emitting diode element.

Therefore, in the obtained light emitting diode device, light emitted from the light emitting diode element is reflected by the reflecting resin layer before being absorbed by another member.

As a result, the extraction efficiency of the light can be improved.

A method for producing a light emitting diode device of the present invention includes the steps of providing a reflecting resin layer on one surface in a thickness direction of a first release substrate, forming a through hole in the first release substrate and the reflecting resin layer such that the through hole extends therethrough in the thickness direction to prepare the above-described reflecting resin sheet, laminating the reflecting resin sheet on one surface in the thickness direction of a substrate so as to bring the reflecting resin layer into contact with the substrate, disposing a light emitting diode element on one surface in the thickness direction of the substrate, bringing the reflecting resin layer into close contact with a side surface of the light emitting diode element, and peeling off the first release substrate from the reflecting resin layer.

In this method, the reflecting resin layer is brought into close contact with the side surface of the light emitting diode element.

Therefore, in the light emitting diode device obtained by the above-described method, the light emitted from the light emitting diode element is reflected by the reflecting resin layer before being absorbed by another member.

As a result, the extraction efficiency of the light can be improved.

In the method for producing the light emitting diode device of the present invention, it is preferable that in the step of bringing the reflecting resin layer into close contact with the side surface of the light emitting diode element, the first release substrate is pressed toward the substrate.

In this method, the first release substrate is pressed toward the substrate. Accordingly, the reflecting resin layer sandwiched between the first release substrate and the substrate in the thickness direction fluidly moves to the side. Therefore, when the inner circumference surface of the through hole in the reflecting resin layer is disposed in opposed relation to the side surface of the light emitting diode element, the reflecting resin layer can be reliably brought into close contact with the side surface of the light emitting diode element.

In the method for producing the light emitting diode device of the present invention, it is preferable that the substrate is a diode board and in the step of disposing the light emitting diode element on one surface in the thickness direction of the substrate, the light emitting diode element is disposed in the through hole of the reflecting resin sheet and is flip mounted on the substrate.

According to this method, when the reflecting resin sheet formed with the through hole is accurately disposed with respect to the substrate, which is the diode board, by subsequently disposing the light emitting diode element in the through hole of the reflecting resin sheet, it is possible to allow easy, accurate, and reliable positioning of the light emitting diode element with respect to the substrate, while the light emitting diode element is allowed to be flip mounted on the substrate.

In the method for producing the light emitting diode device of the present invention, it is preferable that the substrate is a second release substrate, and the method for producing the light emitting diode device further includes the steps of peeling off the substrate from the reflecting resin layer and the light emitting diode element and flip mounting the light emitting diode element on the diode board.

In this method, the light emitting diode element which has the side surface thereof in close contact with the reflecting resin layer and from which the substrate, which is the second release substrate, is peeled off is flip mounted on the diode board, so that the light emitting diode device can be easily produced.

A light emitting diode device of the present invention includes a diode board, a light emitting diode element flip mounted on the diode board, and a reflecting resin layer in close contact with a side surface of the light emitting diode element.

In the light emitting diode device, light emitted from the light emitting diode element is reflected by the reflecting resin layer before being absorbed by another member.

As a result, the extraction efficiency of the light can be improved.

It is preferable that the light emitting diode device of the present invention further includes a phosphor layer formed on one surface in the thickness direction of the light emitting diode element.

The light emitting diode device can emit high-energy white light by color mixing of the light emitted from the light emitting diode element and light that is converted in wavelength by the phosphor layer.

### BRIEF DESCRIPTION OF THE DRAWINGS

FIG. 1 shows a plan view of one embodiment of a light emitting diode device of the present invention.
FIG. 2 shows process drawings for illustrating one embodiment of a method for producing the light emitting diode device of the present invention:
   (a) illustrating a step of providing a reflecting resin layer on the upper surface of a first release substrate,
   (b) illustrating a step of forming through holes in the first release substrate and the reflecting resin layer,
   (c) illustrating a step of laminating a reflecting resin sheet on the upper surface of a diode board, and
   (d) illustrating a step of disposing light emitting diode elements in the through holes of the reflecting resin sheet.

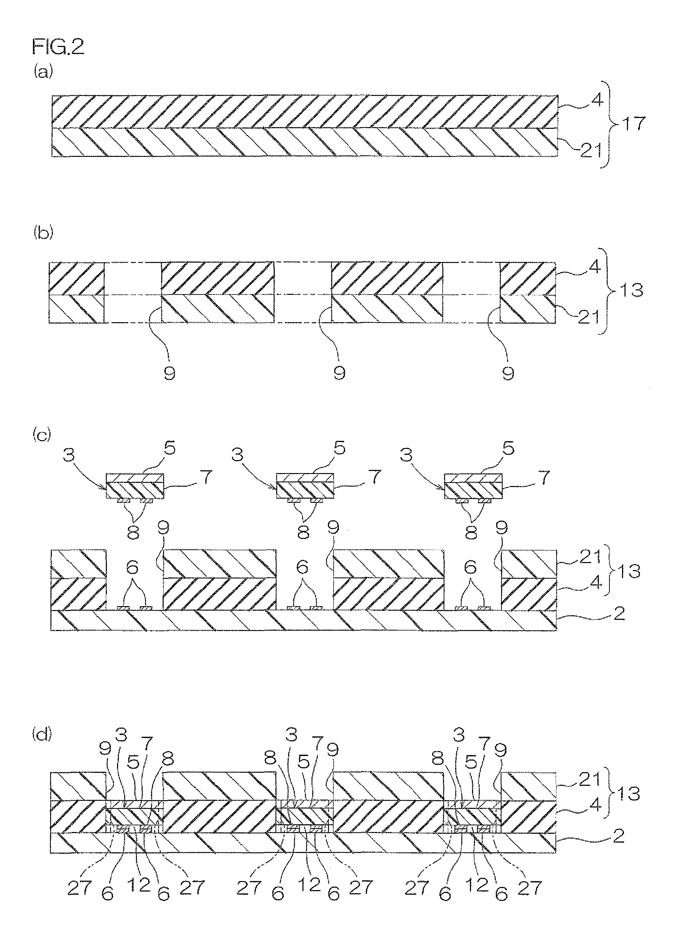

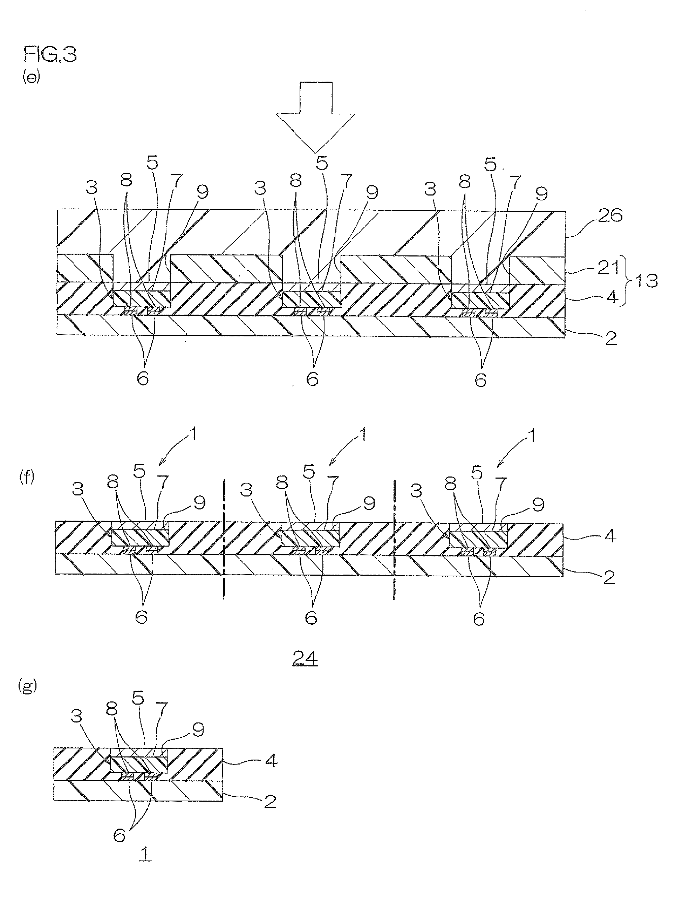

FIG. 3 shows process drawings for illustrating one embodiment of a method for producing the light emitting diode device of the present invention, subsequent to FIG. 2:
   (e) illustrating a step of pressing the first release substrate toward the diode board,
   (f) illustrating a step of detaching a buffer sheet and peeling off the first release substrate, and
   (g) illustrating a step of individualizing the light emitting diode elements.

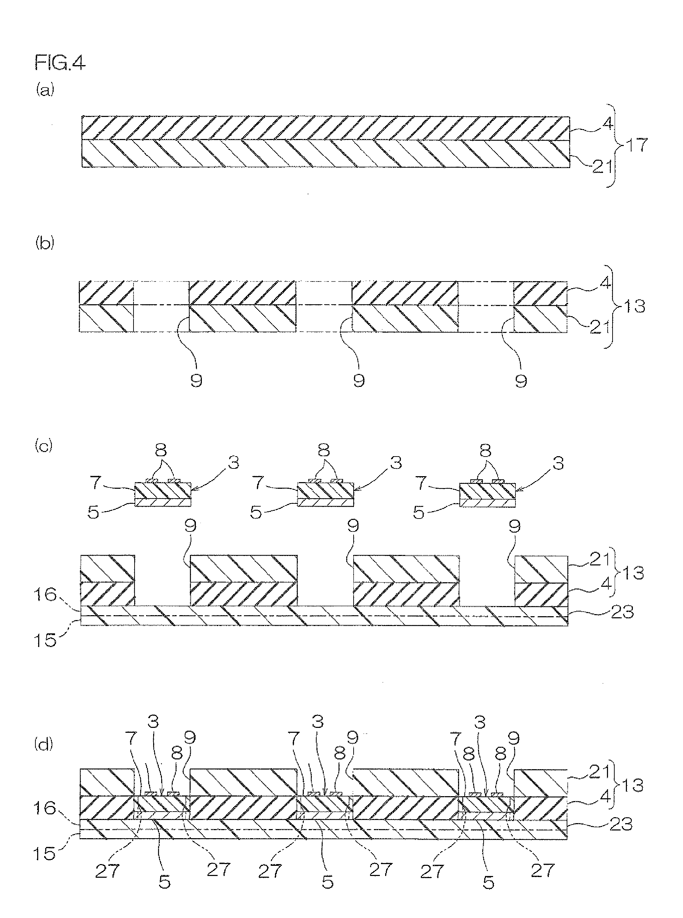

FIG. 4 shows process drawings for illustrating another embodiment (an embodiment in which a second release substrate is used) of a method for producing the light emitting diode device of the present invention:
   (a) illustrating a step of providing the reflecting resin layer on the upper surface of the first release substrate,
   (b) illustrating a step of forming the through holes in the first release substrate and the reflecting resin layer,
   (c) illustrating a step of laminating the reflecting resin sheet on the upper surface of the second release substrate, and
   (d) illustrating a step of disposing the light emitting diode elements in the through holes of the reflecting resin sheet.

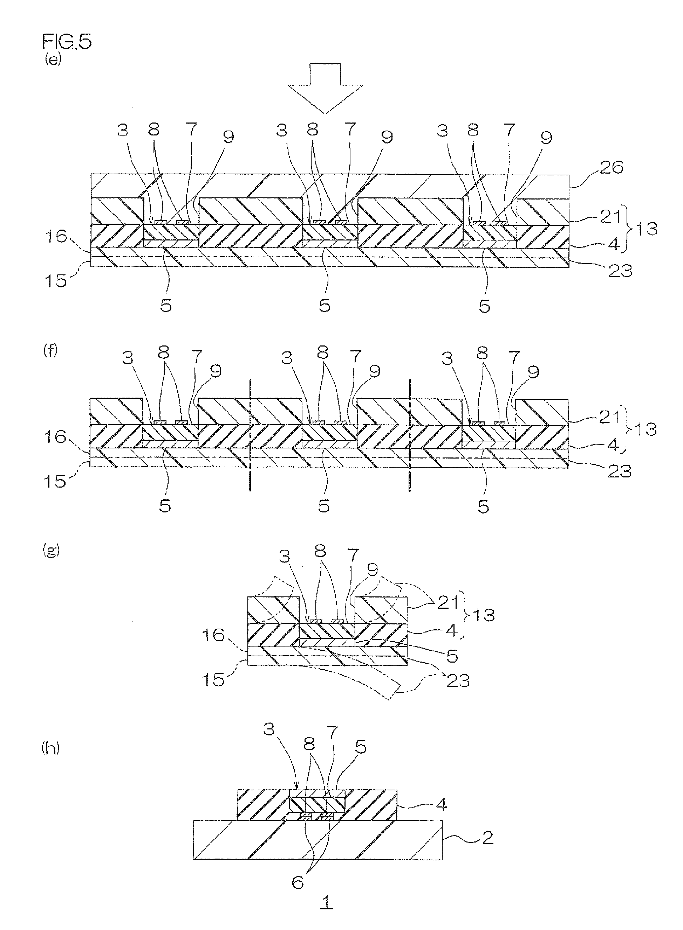

FIG. 5 shows process drawings for illustrating another embodiment (an embodiment in which the second release substrate is used) of a method for producing the light emitting diode device of the present invention, subsequent to FIG. 4:
   (e) illustrating a step of pressing the first release substrate toward the diode board,
   (f) illustrating a step of detaching the buffer sheet,
   (g) illustrating a step of individualizing the light emitting diode elements, and
   (h) illustrating a step of flip mounting the light emitting diode elements on the diode board.

### DETAILED DESCRIPTION OF THE INVENTION

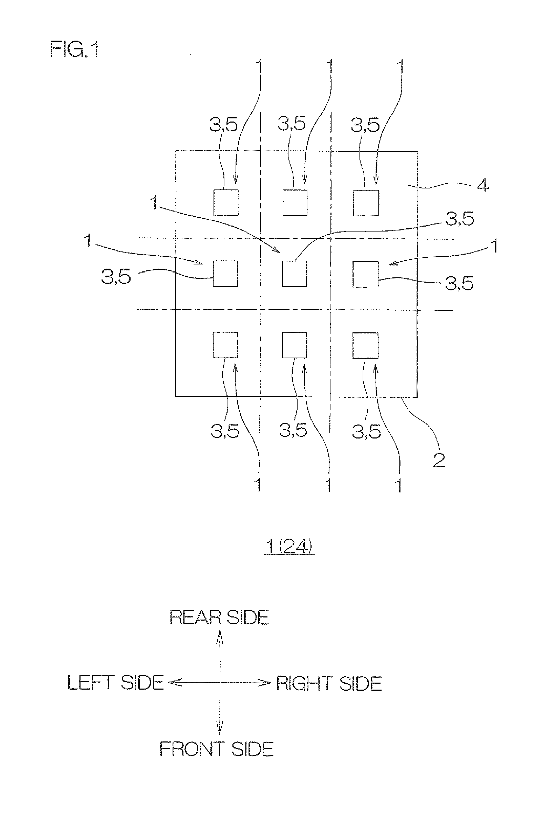

FIG. 1 shows a plan view of one embodiment of a light emitting diode device of the present invention. FIGS. 2 and 3 show process drawings for illustrating one embodiment of a method for producing the light emitting diode device of the present invention.

In FIGS. 1 and 3(f), a light emitting diode device 1 includes a diode board 2 as a substrate, a light emitting diode element 3 flip mounted on the diode board 2, a phosphor layer 5 laminated on the upper surface (one surface in a thickness direction) of the light emitting diode element 3, and a reflecting resin layer 4 provided at the lateral side of the light emitting diode element 3 and the phosphor layer 5.

A plurality of the light emitting diode devices 1 are provided to be spaced apart from each other in a plane direction (to be specific, a right-left direction of the paper surface and a front-rear direction of the paper surface shown by the arrows in FIG. 1). To be specific, a plurality of the light emitting diode devices 1 include the common diode board 2 and on one piece of the diode board 2, a plurality of the light emitting diode elements 3, the reflecting resin layer 4 provided at the side thereof, and a plurality of the phosphor layers 5 provided on the respective light emitting diode elements 3 are provided. A plurality of the light emitting diode devices 1 form an assembly sheet 24.

As shown in the dash-dot lines in FIG. 1 and the dash-dot lines in FIG. 3(f), the diode board 2 and the reflecting resin layer 4, which are located between the light emitting diode elements 3, are subjected to a cutting (dicing, described later) process along the thickness direction, so that, as shown in FIG. 3(g), it is also possible to obtain the individualized light emitting diode devices 1.

The diode board 2 is formed into a generally rectangular flat plate shape. To be specific, the diode board 2 is formed of a laminated board in which a conductive layer, as a circuit pattern, is laminated on an insulating board. The insulating board is formed of, for example, a silicon board, a ceramic board, a polyimide resin board, or the like. Preferably, the insulating board is formed of the ceramic board, to be specific, a sapphire (Al₂O₃) board. The conductive layer is formed of, for example, a conductor such as gold, copper, silver, or nickel. The conductors can be used alone or in combination.

The conductive layer includes a terminal 6.

The terminals 6 are formed at spaced intervals in the plane direction on the upper surface of the insulating board and are formed into a pattern corresponding to electrode portions 8 to be described later. Although not shown, the terminal 6 is electrically connected to an electric power supply portion via the conductive layer.

The diode board 2 has a thickness in the range of, for example, 25 to 2000 µm, or preferably 50 to 1000 µm.

The light emitting diode element 3 is provided on the upper surface (one surface in the thickness direction) of the diode board 2 and is formed into a generally rectangular shape in plane view. A plurality of the light emitting diode elements 3 are, on the upper surface of one piece of the diode board 2, arranged to be aligned at spaced intervals to each other in the plane direction (in the right-left direction and the front-rear direction shown by the arrows in FIG. 1).

As shown in FIG. 3(f), each of the light emitting diode elements 3 includes a light semiconductor layer 7 and the electrode portions 8 formed on the lower surfaces thereof.

The light semiconductor layer 7 is formed into a generally rectangular shape in plane view corresponding to the outer shape of the light emitting diode element 3 and is formed into a generally rectangular shape in sectional view that is long in the plane direction.

Although not shown, for example, the light semiconductor layer 7 includes a buffer layer, an N-type semiconductor layer, a light emitting layer, and a P-type semiconductor layer that are successively laminated in a descending order. The light semiconductor layer 7 is formed of a known semiconductor material and is formed by a known growth method such as an epitaxial growth method. The light semiconductor layer 7 has a thickness in the range of, for example, 0.1 to 500 µm, or preferably 0.2 to 200 µm.

The electrode portion 8 is electrically connected to the light semiconductor layer 7 and is formed so as to be included in the light semiconductor layer 7 when projected in the thickness direction. The electrode portion 8 includes, for example, an anode electrode that is connected to the P-type semiconductor layer and a cathode electrode that is formed in the N-type semiconductor layer.

The electrode portion 8 is formed of a known conductive material and has a thickness in the range of, for example, 10 to 1000 nm.

The phosphor layer 5 is formed into a generally rectangular shape in plane view corresponding to the outer shape of the light emitting diode element 3 and is formed over the entire upper surface of the light emitting diode element 3.

The phosphor layer 5 is formed of, for example, a phosphor composition that contains a phosphor.

The phosphor composition contains, for example, the phosphor and a resin.

An example of the phosphor includes a yellow phosphor that is capable of converting blue light into yellow light. An example of the phosphor includes a phosphor obtained by doping a metal atom such as cerium (Ce) or europium (Eu) into a composite metal oxide, a metal sulfide, or the like.

To be specific, examples of the phosphor include garnet type phosphor having a garnet type crystal structure such asY₃Al₅O₁₂:Ce (YAG (yttrium aluminum garnet):Ce), (Y,Gd)₃Al₅O₁₂:Ce, Tb₃Al₃O₁₂:Ce, Ca₃Sc₂Si₃O₁₂:Ce, and Lu₂CaMg₂(Si,Ge)₃O₁₂:Ce; silicate phosphor such as (Sr,Ba)₂SiO₄:Eu, Ca₃SiO₄Cl₂:Eu, Sr₃SiO₅:Eu, Li₂SrSiO₄:Eu, and Ca₃Si₂O₇:Eu; aluminate phosphor such as CaAl₁₂O₁₉:Mn and SrAl₂O₄:Eu; sulfide phosphor such as ZnS:Cu, Al, CaS:Eu, CaGa₂S₄:Eu, and SrGa₂S₄:Eu; oxynitride phosphor such as CaSi₂O₂N₂:Eu, SrSi₂O₂N₂:Eu, BaSi₂O₂N₂:Eu, and Ca-α-SiAlON; nitride phosphor such as CaAlSiN₃:Eu and CaSi₅N₈:Eu; and fluoride-based phosphor such as K₂SiF₆:Mn and K₂TiF₆:Mn. Preferably, garnet type phosphor is used, or more preferably, Y₃Al₅O₁₂:Ce (YAG) is used.

The phosphors can be used alone or in combination of two or more.

The mixing ratio of the phosphor with respect to the phosphor composition is, for example, 1 to 50 mass %, or preferably 5 to 30 mass %. The mixing ratio of the phosphor is, for example, 1 to 100 parts by mass, or preferably 5 to 40 parts by mass per 100 parts by mass of a resin.

The resin is a matrix in which the phosphor is dispersed, including, for example, transparent resins such as silicone resin, epoxy resin, and acrylic resin. Preferably, the silicone resin is used from the viewpoint of durability.

The silicone resin has, in its molecule, a main chain mainly composed of the siloxane bond (-Si-O-Si-) and a side chain, which is bonded to silicon atoms (Si) of the main chain, composed of an organic group such as an alkyl group (for example, a methyl group and the like) or an alkoxyl group (for example, a methoxy group).

To be specific, examples of the silicone resin include dehydration condensation type silicone resin, addition reaction type silicone resin, peroxide curable silicone resin, moisture curable silicone resin, and curable silicone resin. Preferably, the addition reaction type silicone resin is used.

The silicone resin has a kinetic viscosity at 25°C in the range of, for example, 10 to 30 mm²/s.

The resins can be used alone or in combination of two or more.

The mixing ratio of the resin is, for example, 50 to 99 mass %, or preferably 70 to 95 mass % with respect to the phosphor composition.

The phosphor and the resin are blended at the above-described mixing ratio and are stirred and mixed, so that the phosphor composition is prepared.

The phosphor layer 5 can also be formed of, for example, a ceramic of a phosphor (phosphor ceramic plate). In that case, the above-described phosphor is used as a ceramic material and by sintering such a ceramic material, the phosphor layer 5 (phosphor ceramic) is obtained.

The phosphor layer 5 has a thickness in the range of, for example, 100 to 1000 µm, preferably 200 to 700 µm, or more preferably 300 to 500 µm.

The reflecting resin layer 4 is formed on the upper surface of the diode board 2 such that, when the reflecting resin layer 4 is projected in the thickness direction, the circumference end edge thereof is at the same position as that of the circumference end edge of the diode board 2. Also, when projected in the thickness direction, the reflecting resin layer 4 is formed in a region at least other than the regions where the light emitting diode elements 3 (to be specific, the electrode portions 8) are formed.

That is, the reflecting resin layer 4 is disposed so as to surround the respective side surfaces of the light emitting diode elements 3 and the phosphor layers 5 and also cover the lower surfaces of the light semiconductor layers 7 exposed from the electrode portions 8.

To be specific, as shown in FIG. 1, the reflecting resin layer 4 is formed into a generally rectangular frame shape on both outer sides of each of the light emitting diode elements 3 and each of the phosphor layers 5 in the right-left direction and in the front-rear direction. With its frame portion being arranged to be continuously aligned in the right-left direction and in the front-rear direction, the reflecting resin layer 4 is formed into a generally grid shape in plane view over the upper surface of one piece of the diode board 2.

To be more specific, as shown in FIG. 3(f), the reflecting resin layer 4 is in close contact with each of the respective outer side surfaces of the light emitting diode elements 3 and the phosphor layers 5, to be specific, each of the surfaces of the left surface, the right surface, the front surface (ref: FIG. 1), and the rear surface (ref: FIG. 1) of each of the light emitting diode elements 3 and each of the phosphor layers 5. The reflecting resin layer 4 also exposes the upper surfaces of the phosphor layers 5.

At the lower side of the light semiconductor layer 7, lower space 12 (ref: FIG. 2(d)) each corresponding to the thickness of each of the electrode portions 8 are formed and are also filled with the reflecting resin layer 4. In this way, the reflecting resin layer 4 is also in close contact with the lower surfaces of the light semiconductor layers 7 exposed from the electrode portions 8 and the side surfaces of the electrode portions 8.

The upper surface of the reflecting resin layer 4 is formed to be substantially flush with the upper surfaces of the phosphor layers 5 in the plane direction.

The above-described reflecting resin layer 4 contains, for example, a light reflecting component. To be specific, the reflecting resin layer 4 is formed of a reflecting resin composition that contains a resin and the light reflecting component.

An example of the resin includes a thermosetting resin such as thermosetting silicone resin, epoxy resin, thermosetting polyimide resin, phenol resin, urea resin, melamine resin, unsaturated polyester resin, diallyl phthalate resin, and thermosetting urethane resin. Preferably, the thermosetting silicone resin or the epoxy resin is used.

The light reflecting component is, for example, a white compound. To be specific, an example of the white compound includes a white pigment.

An example of the white pigment includes a white inorganic pigment. Examples of the white inorganic pigment include an oxide such as titanium oxide, zinc oxide, and zirconium oxide; a carbonate such as white lead (lead carbonate) and calcium carbonate; and a clay mineral such as kaoline (kaolinite).

As the white inorganic pigment, preferably, the oxide is used or more preferably, the titanium oxide is used.

The titanium oxide can have characteristics such as a high degree of whiteness, a high light reflectivity, excellent hiding characteristics (hiding power), excellent coloring characteristics (coloring power), a high dispersibility, an excellent weather resistance, and a high chemical stability.

To be specific, the titanium oxide is TiO₂ (titanium oxide (IV), titanium dioxide).

A crystal structure of the titanium oxide is not particularly limited. For example, the crystal structure thereof is rutile, brookite (pyromelane), anatase (octahedrite), or the like. Preferably, the crystal structure thereof is rutile.

A crystal system of the titanium oxide is not particularly limited. For example, the crystal system thereof is a tetragonal system, an orthorhombic system, or the like. Preferably, the crystal system thereof is the tetragonal system.

When the crystal structure and the crystal system of the titanium oxide are rutile and the tetragonal system, respectively, it is possible to effectively prevent a reduction of the reflectance with respect to light (to be specific, visible light, among all, the light around the wavelength of 450 nm) even in a case where the reflecting resin layer 4 is exposed to a high temperature for a long time.

The light reflecting component is in the form of a particle. The shape thereof is not limited and examples of the shape thereof include, for example, a sphere shape, a plate shape, and a needle shape. An average value of the maximum length (in a case of the sphere shape, the average particle size) of the light reflecting component is in the range of, for example, 1 to 1000 nm. The average value of the maximum length is measured by using a laser diffraction scattering particle size analyzer.

The mixing ratio of the light reflecting component per 100 parts by mass of the resin is, for example, 0.5 to 90 parts by mass, or preferably 1.5 to 70 parts by mass from the viewpoint of the coloring characteristics, the light reflectivity, and handling ability of the reflecting resin composition.

The above-described light reflecting component is uniformly dispersed and mixed into the resin.

In addition, a filler can further be added into the reflecting resin composition. That is, the filler can be used in combination with the light reflecting component (to be specific, the white pigment).

An example of the filler includes a known filler, except for the above-described white pigment. To be specific, an inorganic filler is used. Examples thereof include silica powder, talc powder, alumina powder, aluminum nitride powder, and silicon nitride powder.

Preferably, as the filler, the silica powder is used from the viewpoint of reducing a linear expansion coefficient of the reflecting resin layer 4.

Examples of the silica powder include fused silica powder and crystalline silica powder. Preferably, the fused silica powder (that is, silica glass powder) is used.

Examples of the shape of the filler include, for example, a sphere shape, a plate shape, and a needle shape. Preferably, the sphere shape is used from the viewpoint of excellent filling characteristics and fluidity.

Therefore, preferably, the fused silica powder in a sphere shape is used as the silica powder.

The average value of the maximum length (in a case of the sphere shape, the average particle size) of the filler is in the range of, for example, 5 to 60 µm, or preferably 15 to 45 µm. The average value of the maximum length is measured by using the laser diffraction scattering particle size analyzer.

The addition ratio of the filler is adjusted so that the total amount of the filler and the light reflecting component per 100 parts by mass of the resin is, for example, 10 to 80 parts by mass. And the addition ratio of the filler is adjusted so that the total amount of the filler and the light reflecting component per 100 parts by mass of the resin is preferably 25 to 75 parts by mass, or more preferably 40 to 60 parts by mass from the view point of reducing the linear expansion coefficient and ensuring the fluidity.

The above-described resin, light reflecting component, and filler, which is added as required, are blended to be uniformly mixed, so that the reflecting resin composition is prepared.

Also, the reflecting resin composition is prepared in a B-stage state.

The reflecting resin composition is formed, for example, in a state of liquid or semi-solid and has a kinetic viscosity in the range of, for example, 10 to 30 mm²/s.

The reflecting resin layer 4 has a thickness in the range of, for example, 25 to 500 µm, or preferably 50 to 300 µm.

Next, a method for producing the above-described light emitting diode device 1 is described with reference to FIGS. 1 to 3.

In this method, as shown in FIG. 2(b), a reflecting resin sheet 13 is first prepared.

The reflecting resin sheet 13 shown in FIG. 2(b) is a transfer sheet for transferring the reflecting resin layer 4 onto the lateral sides of the light emitting diode elements 3 (ref: FIG. 2(c)).

The reflecting resin sheet 13 includes a first release substrate 21 and the reflecting resin layer 4 provided on the upper surface (one surface in the thickness direction) of the first release substrate 21.

To obtain the reflecting resin sheet 13, as referred in FIG. 2(a), the reflecting resin layer 4 is first provided on the upper surface (one surface in the thickness direction) of the first release substrate 21 to obtain a laminated sheet 17.

To provide the reflecting resin layer 4 on the upper surface of the first release substrate 21, for example, the first release substrate 21 is first prepared.

The first release substrate 21 is formed of a resin material and the like such as a vinyl polymer including polyolefin (to be specific, polyethylene and polypropylene) and ethylene-vinyl acetate copolymer (EVA); a polyester including polyethylene terephthalate and polycarbonate; and a fluorine resin including polytetrafluoroethylene. The first release substrate 21 is also formed of a metal material such as iron, aluminum, or stainless steel.

The first release substrate 21 has a thickness in the range of, for example, 10 to 1000 µm.

Next, the reflecting resin layer 4 is laminated over the entire upper surface (one surface in the thickness direction) of the first release substrate 21.

To laminate the reflecting resin layer 4 over the entire upper surface of the first release substrate 21, the reflecting resin composition is applied onto the entire upper surface of the first release substrate 21, for example, by a known application method such as a dispenser. In this way, a reflecting film is formed and by heating the formed reflecting film, the reflecting resin layer 4 in a sheet state is obtained. The reflecting resin layer 4 is brought into a B-stage state by being heated.

The heating conditions include a heating temperature in the range of, for example, 40 to 150°C, or preferably 50 to 140°C and a heating time in the range of, for example, 1 to 60 minutes, or preferably 3 to 20 minutes.

In this way, the laminated sheet 17 including the first release substrate 21 and the reflecting resin layer 4 laminated on the upper surface thereof is obtained.

Thereafter, as shown in FIG. 2(b), through holes 9 are formed to extend through the laminated sheet 17 in the thickness direction.

That is, as referred in FIG. 2(c), the through holes 9 are formed so as to correspond to the light emitting diode elements 3. To be specific, when the reflecting resin sheet 13 that is turned over upside down is laminated on the diode board 2, the through holes 9 are formed into shapes (to be specific, generally rectangular shapes in plane view) which are substantially the same as those of the regions where the light emitting diode elements 3 and the phosphor layers 5 are disposed and in which the inner circumference surfaces of the through holes 9 in the reflecting resin layer 4 can be disposed in opposed relation to the respective side surfaces of the light emitting diode elements 3 and the phosphor layers 5.

The maximum length of the through hole 9 is not particularly limited and is in the range of, for example, 1 to 10000 µm.

To form the through holes 9 in the laminated sheet 17, a known perforation method such as etching (for example, dry etching), punching using a mold die, or drilling is used.

In this way, the first release substrate 21 and the reflecting resin layer 4 are perforated to communicate with each other and the through holes 9 having the above-described pattern are formed in the laminated sheet 17.

In this way, the reflecting resin sheet 13 can be formed.

Next, in this method, as shown in the lower portion in FIG. 2(c), the reflecting resin sheet 13 is laminated on the diode board 2.

That is, the reflecting resin sheet 13 shown in FIG. 2(b) is first turned over upside down.

Then, the turned over reflecting resin sheet 13 is laminated on the upper surface (one surface in the thickness direction) of the diode board 2 so that the reflecting resin layer 4 is in contact with the diode board 2.

Next, in this method, as shown in the upper portion in FIG. 2(c), the light emitting diode elements 3 each having the phosphor layer 5 laminated on the upper surfaces thereof are prepared.

To be specific, the phosphor layer 5 is first prepared and then, the light emitting diode elements 3 are laminated on the upper surface of the phosphor layers 5. Thereafter, the phosphor layers 5 and the light emitting diode elements 3 are turned over upside down.

When the phosphor layer 5 is formed of the phosphor composition, the phosphor composition is, for example, applied onto the upper surface of a release film not shown to form a phosphor film (not shown). Then, the phosphor film is heated at, for example, 50 to 150°C to be dried, so that the phosphor layer 5 in a sheet state is obtained. Thereafter, the release film is peeled off from the phosphor layer 5.

Alternatively, when the phosphor layer 5 is formed of a ceramic of a phosphor (phosphor ceramic plate), for example, the above-described phosphor is used as a ceramic material, which is formed into a sheet state, and then is sintered to obtain the phosphor layer 5 (phosphor ceramic) in a sheet state.

Next, the light semiconductor layer 7 is formed on the upper surface of the phosphor layer 5 in a predetermined pattern by a known growth method such as an epitaxial growth method. Then, the electrode portions 8 are formed on the upper surface of the light semiconductor layer 7 in the above-describe pattern.

In this way, the light emitting diode elements 3 are formed on the upper surface of the phosphor layer 5. Then, a cutting (dicing) process is performed to form generally rectangular shapes in plane view with predetermined sizes as required, each of which includes at least one piece of the light emitting diode element 3 (ref: FIG. 1).

Thereafter, the phosphor layers 5 and the light emitting diode elements 3 are turned over upside down to prepare the light emitting diode elements 3 having the phosphor layers 5 laminated on the upper surfaces thereof.

Next, as shown in FIG. 2(d), the light emitting diode elements 3 are disposed on the upper surface (one surface in the thickness direction) of the diode board 2.

To be specific, the light emitting diode elements 3 are disposed in the through holes 9 of the reflecting resin sheet 13 to be flip mounted on the diode board 2. The flip mounting (also called flip-chip mounting) is performed by electrically connecting the electrode portions 8 to the terminals 6.

Thereafter, as shown in FIG. 3(e), a buffer sheet 26 is provided on the upper surface of the reflecting resin sheet 13.

The buffer sheet 26 is a sheet (a cushion sheet) that buffers a pressing force so as not to allow the pressing force to non-uniformly apply to the light emitting diode elements 3 in the pressing to be described next (ref: the arrow in FIG. 3(e)). The buffer sheet 26 is formed of, for example, an elastic sheet (film) and the like.

A buffer material for forming the buffer sheet 26 includes the same resin material as that for forming the first release substrate 21 described above. Preferably, the buffer sheet 26 is formed of vinyl polymer, or more preferably, the buffer sheet 26 is formed of EVA.

The buffer sheet 26 has a thickness in the range of, for example, 0.01 to 1 mm, or preferably 0.05 to 0.2 mm.

To be specific, the buffer sheet 26 is, in plane view, formed on the upper surface of the reflecting resin sheet 13 (the first release substrate 21) including the through holes 9.

Subsequently, as shown by the arrow in FIG. 3(e), the reflecting resin sheet 13 is pressed toward the lower side.

To be specific, the reflecting resin sheet 13 with respect to the diode board 2 is pressed via the buffer sheet 26, for example, with a pressing machine or the like.

The pressure is in the range of, for example, 0.01 to 7 MPa, or preferably 0.05 to 4 MPa.

The above-described pressing can be performed together with heating as required. That is, hot pressing (to be specific, hot pressing in which the pressing is performed with a hot plate) can be performed.

The heating temperature is in the range of, for example, 25 to 140°C.

Since the reflecting resin layer 4 is sandwiched between the first release substrate 21 and the diode board 2, the pressing force applied to the reflecting resin layer 4 in the thickness direction transmits to the side, to be specific, outwardly (leftwardly, rightwardly, forwardly, and rearwardly) in the plane direction. In this way, the reflecting resin layer 4 comes in close contact with the respective side surfaces (the left surfaces, the right surfaces, the front surfaces, and the rear surfaces) of the light emitting diode elements 3 and the phosphor layers 5.

As referred in the phantom lines in FIG. 2(d), when the light emitting diode elements 3 are disposed in the through holes 9, minute side space 27 may be formed between the inner circumference surfaces of the through holes 9 in the reflecting resin layer 4 and the side surfaces of the light emitting diode elements 3. In that case, by the above-described pressing, the reflecting resin layer 4 also fluidly moves outwardly (leftwardly, rightwardly, forwardly, and rearwardly) in the plane direction, so that the side space 27 are filled with the reflecting resin layer 4.

By the above-described pressing, the lower space 12 are also filled with the reflecting resin layer 4. Therefore, the reflecting resin layer 4 with which the lower space 12 are filled comes in close contact with the lower surfaces of the light semiconductor layers 7 and the side surfaces of the electrode portions 8.

Then, as shown in FIG. 3(f), the buffer sheet 26 (ref: FIG. 3(e)) is removed and subsequently, the first release substrate 21 (ref: FIG. 3(e)) is peeled off from the reflecting resin layer 4.

Then, the reflecting resin layer 4 in a B-stage state is cured by being heated.

In this way, as shown in FIG. 1, the assembly sheet 24 including a plurality of the light emitting diode devices 1 arranged in alignment is obtained.

Thereafter, as shown by the dash-dot lines in FIG. 1 and the dash-dot lines in FIG. 3(f), the diode board 2 and the reflecting resin layer 4, which are located between the light emitting diode elements 3 adjacent to each other, are subjected to a cutting (dicing) process along the thickness direction.

In this way, the light emitting diode elements 3 are cut into plural pieces. That is, the light emitting diode elements 3 are individualized (singulated).

Thus, as shown in FIG. 3(g), the light emitting diode devices 1 including the individualized light emitting diode elements 3 are obtained.

In the above-described method, the reflecting resin layer 4 is brought into close contact with the side surfaces of the light emitting diode elements 3.

Also, in this method, the first release substrate 21 is pressed toward the diode board 2, so that the reflecting resin layer 4 sandwiched between the first release substrate 21 and the diode board 2 in the thickness direction fluidly moves to the side. Since the inner circumference surfaces of the through holes 9 in the reflecting resin layer 4 and the side surfaces of the light emitting diode elements 3 are disposed in opposed relation, the reflecting resin layer 4 can be reliably brought into close contact with the side surfaces of the light emitting diode elements 3.

Therefore, in the light emitting diode device 1 obtained by the above-described method, light emitted from the light emitting diode element 3 to the side is reflected by the reflecting resin layer 4 before being absorbed by another member.

Moreover, the light emitting diode device 1 can emit high-energy white light by color mixing of the blue light emitted from the light emitting diode element 3 upward and the yellow light that is converted in wavelength by the phosphor layer 5.

As a result, the extraction efficiency of the light can be improved.

FIGS. 4 and 5 show process drawings for illustrating another embodiment (an embodiment in which a second release substrate is used) of a method for producing the light emitting diode device of the present invention.

In the embodiments in FIGS. 2 and 3, the substrate in the producing method of the light emitting diode device of the present invention is described as the diode board 2. Alternatively, for example, as shown in FIGS. 4 and 5, it is also possible to obtain the light emitting diode devices 1 by using a second release substrate (release substrate) 23 as the substrate and separately preparing the diode board 2.

Next, a method for producing the light emitting diode device 1 using the second release substrate 23 is described with reference to FIGS. 4 and 5. In FIGS. 4 and 5, the same reference numerals are provided for members corresponding to each of those described above, and their detailed description is omitted.

In this method, as shown in FIG. 4(a), the laminated sheet 17 including the first release substrate 21 and the reflecting resin layer 4 is first prepared. Subsequently, as shown in FIG. 4(b), the through holes 9 are formed in the laminated sheet 17 to prepare the reflecting resin sheet 13.

Subsequently, as shown in the lower portion in FIG. 4(c), the reflecting resin sheet 13 is turned over upside down and then, is laminated on the upper surface of the second release substrate 23 as the substrate.

The second release substrate 23 is formed of the same material as that for the first release substrate 21 described above. The second release substrate 23 can also be formed of a thermal release sheet that can be easily peeled off from the light emitting diode elements 3 and the reflecting resin layer 4 by being heated. As shown in the phantom lines in FIG. 4(c), for example, the thermal release sheet includes a supporting layer 15 and a pressure-sensitive adhesive layer 16 laminated on the upper surface of the supporting layer 15.

The supporting layer 15 is formed of, for example, a heat resistant resin such as polyester.

The pressure-sensitive adhesive layer 16 is formed of, for example, a thermally expandable pressure-sensitive adhesive and the like, which has adhesion under normal temperature (25°C), and in which the adhesion is reduced (or lost) at the time of being heated.

A commercially available product can be used as the above-described thermal release sheet. To be specific, REVALPHA (a trade name, manufactured by NITTO DENKO CORPORATION) and the like can be used.

The thermal release sheet reliably supports the reflecting resin layer 4 and the light emitting diode elements 3 by the supporting layer 15 via the pressure-sensitive adhesive layer 16 and is peeled off from the light emitting diode elements 3 and the reflecting resin layer 4 due to a reduction in the adhesion of the pressure-sensitive adhesive layer 16 by the heating and thermal expansion performed thereafter.

The second release substrate 23 has a thickness in the range of, for example, 10 to 1000 µm.

Next, as shown in FIG. 4(d), the light emitting diode elements 3 are provided on the upper surface of the second release substrate 23.

To be specific, the light emitting diode elements 3 are disposed in the through holes 9 of the reflecting resin sheet 13. In this way, the inner circumference surfaces of the through holes 9 in the reflecting resin sheet 13 are disposed in opposed relation to the respective side surfaces of the light emitting diode elements 3 and the phosphor layers 5. The light emitting diode elements 3 are also disposed in the through holes 9 so as to bring the phosphor layers 5 into contact with the second release substrate 23.

Next, as shown in FIG. 5(e), the buffer sheet 26 is provided on the upper surface of the reflecting resin sheet 13. Subsequently, as shown by the arrow in FIG. 5(e), the reflecting resin sheet 13 is pressed toward the lower side to bring the reflecting resin layer 4 into close contact with the respective side surfaces of the light emitting diode elements 3 and the phosphor layers 5.

Then, as shown in FIG 5(f), the buffer sheet 26 (ref: FIG. 5(e)) is removed.

Subsequently, as shown by the dash-dot lines in FIG. 5(f), the second release substrate 23, the reflecting resin layer 4, and the first release substrate 21, which are located between the light emitting diode elements 3 adjacent to each other, are subjected to a cutting (dicing) process along the thickness direction.

In this way, the light emitting diode elements 3 are cut into plural pieces. That is, as shown in FIG. 5(g), the light emitting diode elements 3 having the side surfaces thereof in close contact with the reflecting resin layer 4 are individualized (singulated).

Then, as shown in the phantom lines in FIG. 5(g), the first release substrate 21 is peeled off from the reflecting resin layer 4, while the second release substrate 23 is peeled off from the light emitting diode element 3 and the reflecting resin layer 4. When the second release substrate 23 is formed of a thermal release sheet, the second release substrate 23 is peeled off by being heated.

Then, as shown in FIG. 5(h), the light emitting diode element 3 is turned over upside down and is flip mounted on the diode board 2.

In the flip mounting, the reflecting resin layer 4 is in a B-stage state so that the lower surface thereof is adhered to the upper surface of the diode board 2, while the reflecting resin layer 4 is buried in the lower space 12 (ref: FIG. 2(d)). Thereafter, the reflecting resin layer 4 is cured by being heated, so that the light emitting diode element 3 is encapsulated by the reflecting resin layer 4.

In this way, the light emitting diode device 1 is obtained.

The embodiments in FIGS. 4 and 5 can achieve the same function effect as achieved by the embodiments in FIGS. 2 and 3.

Additionally, in the embodiments in FIGS. 4 and 5, the light emitting diode element 3 which has the side surfaces thereof in close contact with the reflecting resin layer 4 and from which the second release substrate 23 is peeled off is flip mounted on the diode board 2, so that the light emitting diode device 1 can be easily produced.

On the other hand, according to the embodiments in FIGS. 2 and 3, when the reflecting resin sheet 13 formed with the through holes 9 is accurately disposed on the diode board 2, by subsequently disposing the light emitting diode elements 3 in the through holes 9 of the reflecting resin sheet 13, it is possible to easily and reliably perform accurate positioning of the light emitting diode element 3 with respect to the diode board 2 and flip mount the light emitting diode elements 3 on the diode board 2.

### Examples

While the present invention will be described hereinafter in further detail with reference to Examples, the present invention is not limited to these Examples.

Example 1 (the embodiments in FIGS. 2 and 3)

First, a reflecting resin sheet was prepared (ref: FIG. 2(b)).

That is, a first release substrate made of polyethylene terephthalate having a thickness of 25 µm was first prepared. Then, 100 parts by mass of thermosetting silicone resin and 20 parts by mass of a particle of titanium oxide (TiO₂: tetragonal system of rutile) in a sphere shape having an average particle size of 300 nm were uniformly mixed, so that a reflecting resin composition was prepared. The prepared reflecting resin composition was applied on the entire upper surface of the first release substrate to form a reflecting film. Thereafter, by heating the reflecting film, a reflecting resin layer in a B-stage state having a thickness of 100 µm was formed over the entire upper surface of the first release substrate to form a laminated sheet including the first release substrate and the reflecting resin layer (ref: FIG. 2(a)).

Then, through holes in rectangular shapes in plane view each having a maximum length of 400 µm were formed in the laminated sheet by punching using a mold die. In this way, the reflecting resin layer was prepared (ref: FIG. 2(b)).

Next, the reflecting resin sheet was turned over upside down. Thereafter, the turned over reflecting resin sheet was laminated on the upper surface of a diode board having a thickness of 1 mm (ref: the lower portion in FIG. 2(c)).

Separately, phosphor layers were prepared. Then, light emitting diode elements were laminated on the upper surfaces of the phosphor layers. To be specific, a release film was first prepared. Thereafter, 26 parts by mass of phosphor particles composed of Y₃Al₅O₁₂:Ce (in a sphere shape, the average particle size of 8 µm) and 74 parts by mass of a silicone resin (addition reaction type silicone resin, kinetic viscosity (at 25°C) of 20 mm²/s, manufactured by WACKER ASAHIKASEI SILICONE CO., LTD.) were blended and stirred uniformly, so that a phosphor composition was prepared. The phosphor composition was applied on the entire upper surface of the prepared release film to form a phosphor film. Then, the phosphor film was dried at 100°C to form a phosphor layer on the entire upper surface of the release film. Thereafter, the release film was peeled off from the phosphor layers.

Subsequently, light emitting diode elements each having a thickness of 0.1 mm and including a light semiconductor layer including a buffer layer (GaN); an N-type semiconductor layer (n-GaN); a light emitting layer (InGaN); and a P-type semiconductor layer (p-GaN:Mg) and an electrode portion including an anode electrode and a cathode electrode were formed on the upper surfaces of the phosphor layers. In this way, the light emitting diode elements having the phosphor layers laminated on the lower surfaces thereof were formed.

Thereafter, the light emitting diode elements and the phosphor layers were turned over upside down (ref: the upper portion in FIG. 2(c)).

Then, the light emitting diode elements were disposed on the upper surface of a diode board (ref: FIG. 2(d)). To be specific, the light emitting diode elements were disposed in the through holes of the reflecting resin sheet and were flip mounted on the diode board. The flip mounting was performed by electrically connecting the electrode portions and terminals. The inner circumference surfaces of the through holes in the reflecting resin layer and the side surfaces of the light emitting diode elements were disposed in opposed relation in a plane direction.

Thereafter, a buffer sheet made of EVA having a thickness of 0.12 mm was provided on the upper surface of the reflecting resin sheet (ref: FIG. 3(e)).

Then, the reflecting resin sheet with respect to the diode board was pressed via the buffer sheet at a pressure of 0.3 MPa with a pressing machine (ref: the arrow in FIG. 3(e)). In this way, the reflecting resin layer was brought into close contact with the respective side surfaces of the light emitting diode elements and the phosphor layers.

Then, the buffer sheet was removed. Subsequently, the first release substrate was peeled off from the reflecting resin layer (ref: FIG. 3(f)). Thereafter, the reflecting resin layer was cured by being heated.

In this way, an assembly sheet including a plurality of the light emitting diode devices arranged in alignment was obtained (ref: FIG. 1).

Thereafter, the diode board and the reflecting resin layer, which were located between the light emitting diode elements adjacent to each other, were subjected to a dicing process along a thickness direction (ref: the dash-dot lines in FIG. 1 and the dash-dot lines in FIG. 3(f)).

In this way, the light emitting diode elements were individualized to obtain light emitting diode devices including the respective light emitting diode elements (ref: FIG. 3(g)).

Example 2 (the embodiments in FIGS. 4 and 5)

In the same manner as in Example 1, a laminated sheet was formed to form through holes and subsequently, a reflecting resin sheet was prepared (ref: FIGS. 4(a) and 4(b)).

Then, the reflecting resin sheet was turned over upside down. Thereafter, the turned over reflecting resin sheet was laminated on the upper surface of a second release substrate formed of a thermal release sheet (trade name of REVALPHA, manufactured by NITTO DENKO CORPORATION) having a thickness of 100 µm (ref: the lower portion in FIG. 4(c)).

In the same manner as in Example 1, light emitting diode elements were laminated on the upper surfaces of phosphor layers prepared according to the following description and the light emitting diode elements and the phosphor layers were turned over upside down (ref: the upper portion in FIG. 4(c)).

### <Preparation of Phosphor Layer>

4 g of phosphor particles composed of Y₃Al₅O₁₂:Ce (in a sphere shape, the average particle size of 95 nm); 0.2 1 g of poly(vinyl butyl-co-vinyl alcohol co vinyl alcohol) (manufactured by Sigma-Aldrich Co., the weight average molecular weight of 90000 to 120000) serving as a binder resin; 0.012 g of silica powder (manufactured by Cabot Corporation, the trade name of "CAB-O-SIL HS-5") serving as a sintering aid; and 10 mL of methanol were mixed in a mortar to provide a slurry. From the obtained slurry, methanol was removed using a drier to obtain dry powder.

With 700 mg of the dry powder, a uniaxial press mold die of 20 mm x 30 mm size was filled. Then, the dry powder was pressed at a pressure of about 10 tons using a hydraulic pressing machine to obtain a green body in a plate shape molded in a rectangular shape having a thickness of about 350 µm.

The obtained green body was heated in air at a temperature rising rate of 2°C/min to reach the temperature of 800°C in a tubular electric furnace made of alumina so that an organic component such as the binder resin was decomposed/removed, followed by the evacuation of the electric furnace using a rotary pump and 5-hour heating at 1500°C. In this way, phosphor layers each formed of a ceramic plate (YAG-CP) of a YAG:Ce phosphor having a thickness of about 280 urn were prepared.

Then, the light emitting diode elements were disposed on the upper surface of the second release substrate (ref: FIG. 4(d)). To be specific, the light emitting diode elements and the phosphor layers were disposed in the through holes of the reflecting resin sheet. The inner circumference surfaces of the through holes in the reflecting resin layer and the respective side surfaces of the light emitting diode elements and the phosphor layers were disposed in opposed relation in the plane direction.

Thereafter, a buffer sheet made of EVA having a thickness of 0.12 mm was provided on the upper surface of the reflecting resin sheet (ref: FIG. 5(e)).

Then, the reflecting resin sheet with respect to the second release substrate was pressed via the buffer sheet at a pressure of 0.3 MPa with a pressing machine (ref: the arrow in FIG 5(e)).

In this way, the reflecting resin layer was brought into close contact with the respective side surfaces of the light emitting diode elements and the phosphor layers.

Then, the buffer sheet was removed (ref: FIG. 5(f)).

Thereafter, the second release substrate, the reflecting resin layer, and the first release substrate, which were located between the light emitting diode elements adjacent to each other, were subjected to a dicing process along the thickness direction (ref: the dash-dot lines in FIG. 5(f)). In this way, the light emitting diode elements having the side surfaces thereof in close contact with the reflecting resin layer were individualized (ref: FIG. 5(g)).

Then, the first release substrate was peeled off from the upper surface of the reflecting resin layer, while the second release substrate was peeled off from the respective lower surfaces of the light emitting diode element and the reflecting resin layer by being heated (ref: the phantom lines in FIG. 5(g)).

Thereafter, the light emitting diode elements were turned over upside down and were flip mounted on a diode board (ref: FIG. 5(h)). In the flip mounting, the reflecting resin layer was cured by being heated to encapsulate the light emitting diode elements (the side surfaces thereof).

In this way, the light emitting diode devices were obtained.

## Claims

1. A reflecting resin sheet, for providing a reflecting resin layer at the side of a light emitting diode element, comprising:
a first release substrate and
the reflecting resin layer provided on one surface in a thickness direction of the first release substrate, wherein,
in the first release substrate and the reflecting resin layer, a through hole extending therethrough in the thickness direction is formed corresponding to the light emitting diode element so as to allow an inner circumference surface of the through hole in the reflecting resin layer to be disposed in opposed relation to a side surface of the light emitting diode element.

2. A method for producing a light emitting diode device comprising the steps of:
providing a reflecting resin layer on one surface in a thickness direction of a first release substrate,
forming a through hole in the first release substrate and the reflecting resin layer such that the through hole extends therethrough in the thickness direction to prepare a reflecting resin sheet in which the through hole is formed corresponding to the light emitting diode element so as to allow an inner circumference surface of the through hole in the reflecting resin layer to be disposed in opposed relation to a side surface of the light emitting diode element,
laminating the reflecting resin sheet on one surface in the thickness direction of a substrate so as to bring the reflecting resin layer into contact with the substrate,
disposing a light emitting diode element on one surface in the thickness direction of the substrate,
bringing the reflecting resin layer into close contact with a side surface of the light emitting diode element, and
peeling off the first release substrate from the reflecting resin layer.

3. The method for producing the light emitting diode device according to claim 2, wherein
in the step of bringing the reflecting resin layer into close contact with the side surface of the light emitting diode element, the first release substrate is pressed toward the substrate.

4. The method for producing the light emitting diode device according to claim 2, wherein
the substrate is a diode board and
in the step of disposing the light emitting diode element on one surface in the thickness direction of the substrate,
the light emitting diode element is disposed in the through hole of the reflecting resin sheet and is flip mounted on the substrate.

5. The method for producing the light emitting diode device according to claim 2, wherein
the substrate is a second release substrate, and
the method for producing the light emitting diode device further comprising the steps of:
peeling off the substrate from the reflecting resin layer and the light emitting diode element and
flip mounting the light emitting diode element on the diode board.

6. A light emitting diode device comprising:
a diode board,
a light emitting diode element flip mounted on the diode board, and
a reflecting resin layer in close contact with a side surface of the light emitting diode element.

7. The light emitting diode device according to claim 6 further comprising:
a phosphor layer formed on one surface in the thickness direction of the light emitting diode element.
